# EUROPÄISCHE PATENTSCHRIFT

(11) **EP 1 434 896 B1**
(45) Veröffentlichungstag und Bekanntmachung des Hinweises auf die Patenterteilung: **17.11.2010**
(21) Anmeldenummer: 02777255.7
(22) Anmeldetag: 28.09.2002
(51) Int. Cl.: C23C 16/44, C23C 16/54, C23C 14/22, C23C 14/56, F04C 23/00

(54) **MEHRKAMMERVAKUUMANLAGE, VERFAHREN UND VORRICHTUNG ZU IHRER EVAKUIERUNG**
MULTI-CHAMBER INSTALLATION FOR TREATING OBJECTS UNDER VACUUM, METHOD FOR EVACUATING SAID INSTALLATION AND EVACUATION SYSTEM THEREFOR
INSTALLATION MULTICHAMBRE POUR LE TRAITEMENT D'OBJETS SOUS VIDE, PROCEDE PERMETTANT DE FAIRE LE VIDE DE CETTE INSTALLATION ET SYSTEME UTILISE A CET EFFET

(30) Priorität: 11.10.2001 DE 10150015
(43) Veröffentlichungstag der Anmeldung: 07.07.2004
(73) Patentinhaber: Oerlikon Leybold Vacuum GmbH, 50968 Köln (DE)
(72) Erfinder: MÜLLER, Peter, 51107 Köln (DE); ARNDT, Lutz, 53844 Troisdorf (DE)
(74) Vertreter: von Kirschbaum, Alexander
(86) Internationale Anmeldenummer: PCT/EP2002/010918
(87) Internationale Veröffentlichungsnummer: WO 2003/033761

(56) Entgegenhaltungen:
- DE-A- 3 506 433
- DE-A- 10 048 210
- US-A- 5 156 532
- US-A- 5 641 960
- US-B1- 6 251 192

## Beschreibung

Die Erfindung betrifft eine Mehrkammeranlage mit den Merkmalen des Oberbegriffs des Patentanspruchs 1, auf ein Verfahren zum Betrieb der Mehrkammeranlage mit einem an die Kammern angeschlossenen Evakuierungssystem sowie auf ein Evakuierungssystem mit den Merkmalen des Oberbegriffs des Anspruchs 9.

Mehrkammeranlagen der genannten Art sind bekannt. Sie dienen dem Entgasen, Beschichten (z.B. Metallisieren) oder Ätzen von Substraten. Bekannte Verfahren dieser Art sind CVD- oder DVD-Prozesse. Üblicherweise besitzt eine solche Anlage eine Prozesskammer, der eine oder mehrere Vorkammern mit Schleusenfunktion vorgelagert ist. Die Schleusen werden für die Zeit des Ein- oder Ausführens von Substraten geöffnet, so dass hohe und von Kammer zu Kammer unterschiedliche Druckschwankungen auftreten.

Bei einer mit zwei Kammern ausgerüsteten Mehrkammeranlage ist es bekannt, zwei separate Vakuumpumpen einzusetzen, um jede der Kammern nach dem Schließen zugehöriger Schleusen möglichst schnell evakuieren zu können.

Aus der US-A-6 251 192, Figuren 1 und 4, ist eine Mehrkammeranlage der hier betroffenen Art bekannt. Bestandteil des Evakuierungssystems ist eine mehrstufige Vorvakuumpumpe, deren Stufen in Serie angeordnet sind bzw. in Serie betrieben werden. Nachteilig ist, dass die Gase der ersten Stufe auch die nachfolgende(n) Stufe(n) durchströmen. Die nachfolgende(n) Stufe(n) müssen entsprechend dimensioniert sein. Außerdem ist eine gegenseitige Beeinflussung des Pumperhaltens der Pumpstufen unvermeidbar.

Der vorliegenden Erfindung liegt die Aufgabe zu Grunde, bei Mehrkammeranlagen der eingangs genannten oder ähnlichen Art den Aufwand für das Evakuierungssystem zu reduzieren.

Erfindungsgemäß wird diese Aufgabe durch die kennzeichnenden Merkmale der Patentansprüche gelöst.

Dadurch, dass die Pumpstufen der mehrstufigen Vakuumpumpe parallel angeordnet sind bzw. parallel betrieben werden, haben sie die Funktion von zwei unabhängigen Vakuumpumpen. Sie fördern nur die Gase, die in der jeweiligen Kammer, an die sie angeschlossen sind, anfallen. Gegenseitige Beeinflussungen des Durckverhaltens der Pumpstufen sind vermieden.

Typische Vorvakuumpumpen sind ölgedichtete Drehschiebervakuumpumpen, wie sie beispielsweise aus der DE-U-90 07 544 bekannt sind.

Weitere Vorteile und Einzelheiten der Erfindung sollen an Hand von in den Figuren 1 bis 4 schematisch dargestellten Ausführungsbeispielen erläutert werden.

Es-zeigen
- Figur 1 eine Mehrkammeranlage mit drei Kammern und einer dreistufigen Vorvakuumpumpe,
- Figur 2 eine Mehrkammeranlage mit zwei Vakuumkammern und einer zweistufigen Vorvakuumpumpe,
- Figur 3 eine Mehrkammeranlage nach Figur 2 mit einer zusätzlichen Hochvakuumpumpe und
- Figur 4 einen Schnitt durch eine zweistufige Vorvakuumpumpe.

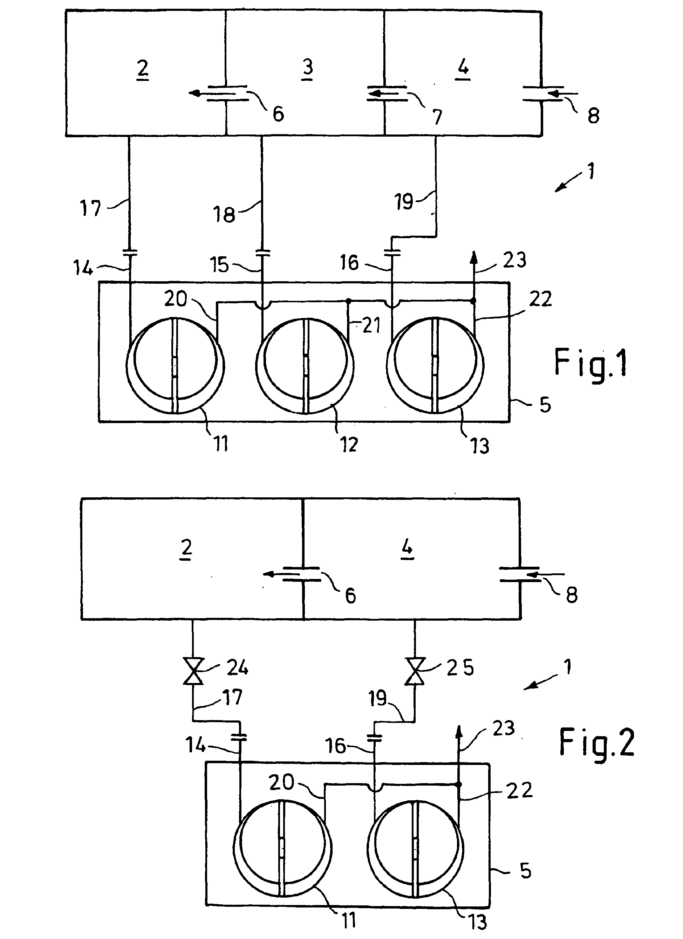

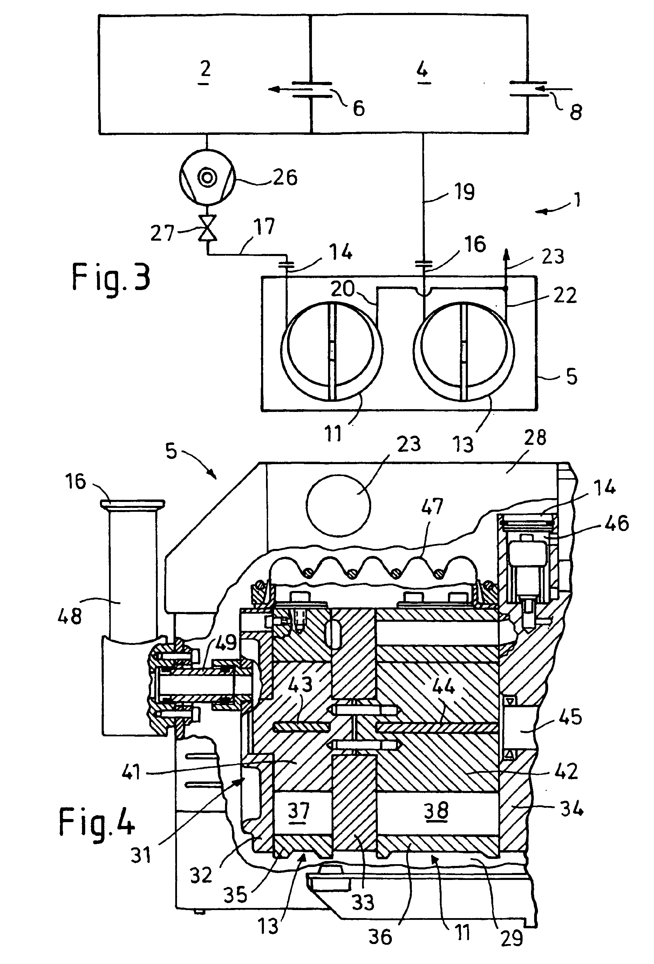

In den Figuren sind die Mehrkammeranlage allgemein mit 1, die Kammern mit 2, 3 und 4 und das Evakuierungssystem mit 5 bezeichnet. Bei den Kammern 2 bis 4 handelt es sich jeweils um eine Prozesskammer 2, der weitere Kammern 3, 4 (Figur 1) bzw. nur 4 (Figuren 2, 3) zugeordnet sind, die z. B. die Funktion von Schleusen haben können. Schlitzschleusen sind schematisch dargestellt und mit 6, 7 und 8 bezeichnet. Das Evakuierungssystem 5 ist als mehrstufige Vorvakuumpumpe ausgebildet.

Beim Ausführungsbeispiel nach Figur 1 sind drei Kammern 2, 3, 4 vorhanden. Dem entsprechend besitzt die Vorvakuumpumpe 5 drei Stufen 11, 12, 13 mit jeweils einem Einlass 14, 15 bzw. 16. Jeder der Einlässe 14, 15, 16 ist über je eine Verbindungsleitung 17, 18 bzw. 19 an eine der Kammern 2, 3, 4 angeschlossen. Die Austritte 20, 21, 22 der Pumpstufen 11, 12, 13 münden innerhalb der Pumpe 5 in eine gemeinsame Auslassleitung, so dass die Pumpe 5 nur einen Auslass 23 besitzt. Haben die Pumpstufen 11, 12, 13 unterschiedliche Saugvermögen, dann ist es zweckmäßig, die Stufe mit dem größten Saugvermögen an die Prozesskammer 2 anzuschließen, damit dort möglichst schnell ausreichend niedrige Drücke erreicht werden können.

Bei der Ausführung nach Figur 2 sind,nur zwei Kammern 2, 4 und dem entsprechend zwei Pumpstufen 11, 13 vorgesehen. In den Verbindungsleitungen 17 und 19 befinden sich Ventile 24 und 25, um eine oder beide Kammern 2, 4 im Falle ihrer Belüftung vom Evakuierungssystem 5 trennen zu können.

Bei der Ausführung nach Figur 3 befinden sich in der Verbindungsleitung 17 eine Turbomolekularvakuumpumpe 26 und - druckseitig davon - ein Ventil 27. Hochvakuumpumpen dieser Art zeichnen sich durch höhere Saugleistungen und niedrigere Enddrücke im Vergleich zu Vorvakuumpumpen aus, benötigen jedoch eine Vorvakuumpumpe, die im dargestellten Fall die Pumpstufe 11 bildet. Diese Ausführung ist für in der Prozesskammer 2 ablaufende Verfahren zweckmäßig, bei denen möglichst schnell relativ niedrige Drücke (z. B. 10⁻² mbar) erreicht werden sollen. Vorvakuumpumpen erreichen zwar auch Enddrücke von etwa 1 mbar bis 5.10⁻² mbar; durch den Einsatz der Hochvakuumpumpen können jedoch wesentlich schneller noch tieferer Drücke erreicht werden.

Figur 4 zeigt einen Teilschnitt durch eine handelsübliche zweistufige Vorvakuumpumpe 5, die für den Einsatz in einer Mehrkammeranlage modifiziert wurde. Sie besitzt ein äußeres Gehäuse 28 mit einem Ölsumpf 29. Im äußeren Gehäuse 28 befindet sich die eigentliche Pumpe 31, eine Drehschiebervakuumpumpe 31 mit zwei Stufen 11 und 13. Sie umfasst drei Scheiben 32, 33, 34 mit dazwischen angeordneten Pumpenringen 35, 36. Die Pumpenringe 35, 36 bilden Schöpfräume 37, 38, in denen sich je ein exzentrisch angeordneter Rotor 41 bzw. 42 mit seinen Schiebern 43 bzw. 44 befindet. Der Rotor 42 ist mit der Welle 45 eines nicht dargestellten Antriebsmotors gekoppelt. Außerdem sind die Lagerstümpfe der Rotoren 41, 42 im Bereich der Scheibe 33 miteinander verbunden. Der Durchmesser der Rotoren 41, 42 ist gleich, ihre Längen sind unterschiedlich. Dadurch ergeben sich für die beiden Pumpstufen 11, 13 unterschiedliche Saugvermögen. Bei der Verwendung der dargestellten Pumpe als zweistufige Vakuumpumpe mit hintereinander geschalteten Pumpstufen 11, 13 bildet die längere die saugseitige und die kürzere die druckseitige Pumpstufe.

Die dargestellte Pumpe 5 ist derart modifiziert worden, dass die Pumpstufen 11, 13 parallel betrieben werden können. Als Einlass 14 der Pumpstufe 11 dient der ohnehin vorhandene, mit einem Saugstutzenventil 46 ausgerüstete Einlass. Der im einzelnen nicht dargestellte Auslass der Pumpstufe 11 steht nicht mehr mit dem Einlass der Pumpstufe 13 in Verbindung sondern mündet unterhalb des Filzhutes 47. Die Pumpstufe 13 ist mit einem unabhängigen Saugstutzen 48 ausgerüstet worden, der den Einlass 16 bildet. Der Saugstutzen 48 steht über den aus dem Gehäuse 28 heraus geführten Rohrabschnitt 49 mit dem Schöpfraum 37 in Verbindung. Der nicht dargestellte Auslass dieser Pumpstufe 13 mündet ebenfalls unterhalb des Filzhutes 47. Der Filzhut 47 hat die Funktionen Strömungsberuhigung und Ölgrobabscheidung. Weitere Abscheider, die an den Auslass 23 angeschlossen werden, müssen im Vergleich zum Stand der Technik nur einmal vorhanden sein.

## Patentansprüche

1. Mehrkammeranlage (1), deren Kammern (2, 3, 4) der Behandlung von Gegenständen unter Vakuum dienen, mit einem an die Kammern (2, 3, 4) angeschlossenen Evakuierungssystem, wobei Bestandteil des Evakuierungssystems eine Vorvakuumpumpe (5) mit mehreren Stufen (11, 12, 13) ist, **dadurch gekennzeichnet, dass** die Pumpstufen (11, 12, 13) der Vorvakuumpumpe (5) parallel angeordnet sind, dass jede der Stufen mit einem Einlass (14, 15, 16) ausgerüstet ist, dass jeder der Einlässe an eine der Kammern (2, 3, 4) angeschlossen ist, dass jede der Stufen mit einem Auslass (20, 21, 22) ausgerüstet ist und dass die Auslässe (20, 21, 22) innerhalb der Vorvakuumpumpe (5) in eine gemeinsame Auslassleitung münden.

2. Anlage nach Anspruch 1, **dadurch gekennzeichnet, dass** die Anzahl der Kammern (2, 3, 4) und die Anzahl der Pumpstufen (11, 12, 13) der Vorvakuumpumpe (5) gleich ist.

3. Anlage nach Anspruch 1 oder 2, **dadurch gekennzeichnet, dass** Bestandteile der Mehrkammeranlage (1) eine Prozesskammer (2) und mindestens eine mit der Prozesskammer (2) verbundene Vorkammer (3, 4) sind, dass die Pumpstufen (11, 12, 13) der Vorvakuumpumpe (5) unterschiedliche Saugvermögen haben und dass die Stufe mit dem größten Saugvermögen an die Prozesskammer (2) angeschlossen ist.

4. Anlage nach Anspruch 3, **dadurch gekennzeichnet, dass** sich in der Verbindungsleitung zwischen der Prozesskammer (2) und dem Einlass (14) der zugehörigen Pumpstufe (11) eine Hochvakuumpumpe (26), vorzugsweise eine Turbomolekularvakuumpumpe, befindet.

5. Verfahren zum Betrieb einer Mehrkammeranlage (1), deren Kammern (2, 3, 4) der Behandlung von Gegenständen unter Vakuum dienen, mit einem an die Kammern (2, 3, 4) angeschlossenen Evakuierungssystem, wobei
- Bestandteil des Evakuierungssystems eine Vorvakuumpumpe (5) mit mehreren Stufen (11, 12, 13) ist,
- die Pumpstufen (11, 12, 13) der Vorvakuumpumpe (5) parallel angeordnet sind,
- jede der Stufen mit einem Einlass (14, 15, 16) ausgerüstet ist,
- jeder der Einlässe an eine der Kammern (2, 3, 4) der Mehrklammeranlage (1) angeschlossen ist,
- jede der Stufen (11, 12, 13) mit einem Auslass (20, 21, 22) ausgerüstet ist und
- die Auslässe (20, 21, 22) innerhalb der Vorvakuumpumpe (5) in eine gemeinsame Auslassleitung münden,
**dadurch gekennzeichnet, dass** die erforderlichen Unterdrücke in den Kammern (2, 3, 4) mit Hilfe der Pumpstufen (11, 12, 13) der Vorvakuumpumpe (5) erzeugt werden und dass die Pumpstufen (11, 12, 13) der Vorvakuumpumpe (5) parallel betrieben werden.

6. Verfahren nach Anspruch 5, **dadurch gekennzeichnet, dass** die Kammern (2, 3, 4) mit Pumpstufen (11, 12, 13) evakuiert werden, die unterschiedliche Saugvermögen haben.

7. Verfahren nach Anspruch 6, **dadurch gekennzeichnet, dass** eine der Kammern (2, 3, 4) eine Prozesskammer (2) ist und dass die Prozesskammer (2) mit Hilfe einer Pumpstufe (11) evakuiert wird, die das größte Saugvermögen hat.

8. Verfahren nach Anspruch 6 oder 7, **dadurch gekennzeichnet, dass** die Prozesskammer (2) mit Hilfe einer Hochvakuumpumpe (26) evakuiert wird und dass der von der Hochvakuumpumpe benötigte Vorvakuumdruck von einer der Pumpstufen (2, 3, 4) erzeugt wird.

9. Evakuierungssystem für eine Mehrkammeranlage (1), deren Kammern (2, 3, 4) der Behandlung von Gegenständen unter Vakuum dienen, wobei Bestandteil des Evakuierungssystems eine Vorvakuumpumpe (5) mit mehreren Stufen (11, 12, 13) ist, **dadurch gekennzeichnet, dass** die Pumpstufen (11, 12, 13) der Vorvakuumpumpe (5) parallel angeordnet ist, dass jede der Stufen mit einen Einlass (14, 15, 16) ausgerüstet ist, dass jeder der Einlässe der Verbindung mit einer der Kammern (2, 3, 4) dient, dass jede der Stufen mit einem Auslass (20, 21, 22) ausgerüstet ist und dass die Auslässe (20, 21, 22) innerhalb der Vorvakuumpumpe (5) in eine gemeinsame Auslassleitung münden.

10. Evakuierungssystem nach Anspruch 9, **dadurch gekennzeichnet, dass** Bestandteil des Systems eine Hochvakuumpumpe (26) ist und dass eine der Stufen (11, 12, 13) der Vorvakuumpumpe (5) der Erzeugung des von der Hochvakuumpumpe (26) benötigten Vorvakuums dient.

11. Evakuierungssystem nach Anspruch 9 oder 10, **dadurch gekennzeichnet, dass** die Auslässe (20, 21, 22) der Pumpstufen (11, 12, 13) innerhalb eines äußeren Gehäuses (28) der Vorvakuumpumpe (5) mit einem gemeinsamen Ölabscheider (47) ausgerüstet sind.

12. Evakuierungssystem nach einem der Ansprüche 9, 10 oder 11, **dadurch gekennzeichnet, dass** die Vorvakuumpumpe (5) eine Drehschiebervakuumpumpe ist.

## Claims

1. A multi-chamber installation (1) whose chambers (2, 3, 4) serve for the treating of objects under vacuum, comprising an evacuation system connected to the chambers (2, 3, 4), the evacuation system having as a component a forevacuum pump (5) with a plurality of stages (11, 12, 13), **characterized in that** the pumping stages (11, 12, 13) of the forevacuum pump (5), that each of the stages is provided with an inlet (14, 15, 16), that each inlet is connected to one of the chambers (2, 3, 4), that each stage is provided with an outlet (20, 21, 22) and that the outlets (20, 21, 22) terminate in a common outlet line within the forevacuum pump (5).

2. The installation according to claim 1, **characterized in that** the number of chambers (2, 3, 4) and the number of pumping stages (11, 12, 13) of the forevacuum pump (5) are equal.

3. The installation according to claim 1 or 2, **characterized in that** the components of the multi-chamber installation (1) are a process chamber (2) and at least one pre-chamber (3, 4) linked to the process chamber (2), that the pumping stages (11, 12, 13) of the forevacuum pump (5) have different pumping capacities, and that the stage with the highest pumping capacity is connected to the process chamber (2).

4. The installation according to claim 3, **characterized in that** a high-vacuum pump (26), preferably a turbomolecular pump, is located in the connecting line between the process chamber (2) and an inlet (14) of the corresponding pumping stage (11).

5. A method for operating a multi-chamber installation (1) for treating objects whose chambers (2, 3, 4) serve for the treating of objects under vacuum, comprising an evacuation system connected to the chambers (2, 3, 4), wherein
- a forevacuum pump (5) with a plurality of stages (11, 12, 13) is a component of the evacuation system,
- the pumping stages (11, 12, 13) of the forevacuum pump (5) being arranged in parallel,
- each of the stages is provided with an inlet (14, 15, 16),
- each of the inlets is connected to one of the chambers (2, 3, 4) of the multi-chamber installation (1),
- each of the stages (11, 12, 13) is provided with an outlet (20, 21, 22), and
- the outlets (20, 21, 22) terminate in a common outlet line inside the forevacuum pump (5),
**characterized in that** the required negative pressures in the chambers (2, 3, 4) are generated by means of the pumping stages (11, 12, 13) of the forevacuum pump (5) and that the pumping stages (11, 12, 13) of the forevacuum pump (5) are operated in parallel.

6. The method according to claim 5, **characterized in that** the chambers (2, 3, 4) are evacuated with pumping stages (11, 12, 13) having different pumping capacities.

7. The method according to claim 6, **characterized in that** one of the chambers (2, 3, 4) is a process chamber (2) and that the process chamber (2) is evacuated with the pumping stage (11) which has the highest pumping capacity.

8. The method according to claim 6 or 7, **characterized in that** the process chamber (2) is evacuated with a high vacuum pump (26), and that the forevacuum pressure required by the high vacuum pump is produced by one of the pumping stages (2, 3, 4).

9. An evacuation system for a multi-chamber installation (1) whose chambers (2, 3, 4) serve for the treating of objects under vacuum, the evacuation system including a multistage forevacuum pump (5) having a plurality of stages (11, 12, 13), **characterized in that** the pumping stages (11, 12, 13) of the forevacuum pump (5) are arranged in parallel, that each of the stages is provided with an inlet (14, 15, 16), that each of the inlets serves for the connection to one of the chambers (2, 3, 4), that each of the sages is provided with an outlet (20, 21, 22) and that the outlets (20, 21, 22) terminate in a common outlet line inside the forevacuum pump (5).

10. The evacuation system according to claim 9, **characterized in that** a high vacuum pump (26) is a component of the system, and that one of the stages (11, 12, 13) of the forevacuum pump (5) serves to produce a forevacuum required by the high vacuum pump (26).

11. The evacuation system according to claim 9 or 10, **characterized in that** the outlets (20, 21, 22) of the pumping stages (11, 12, 13) are provided with a common oil separator (47) inside an outer casing (28) of the forevacuum pump (5).

12. The evacuation system according to one of claims 9, 10 or 11, **characterized in that** the forevacuum pump (5) is a rotary vane vacuum pump.

## Revendications

1. Installation multi-chambre (1) dont les chambres (2, 3, 4) servent à traiter des objets sous vide, comprenant un système d'évacuation raccordé auxdites chambres (2, 3, 4), une pompe à prévide (5) avec plusieurs étages (11, 12, 13) faisant partie dudit système d'évacuation, **caractérisée en ce que** les étages de pompage (11, 12, 13) de ladite pompe à prévide (5) sont arrangés en parallèle, que chaque étage est prévu d'une entrée (14, 15, 16), que chaque entrée est raccordée à une des chambres (2, 3, 4), que chaque étage est prévu d'une sortie (20, 21, 22) et que les sorties (20, 21, 22) débouchent dans une ligne de sortie commune au sein de la pompe à prévide (5).

2. Installation selon la revendication 1, **caractérisée en ce que** le nombre des chambres (2, 3, 4) et le nombre des étages de pompage (11, 12, 13) de ladite pompe à prévide (5) sont égaux.

3. Installation selon les revendications 1 ou 2, **caractérisée en ce que** l'installation multi-chambre (1) comprend comme parties une chambre de traitement (2) et au moins une pré-chambre (3, 4) raccordée à ladite chambre de traitement (2), que les étages de pompage (11, 12, 13) de ladite pompe à prévide (5) ont des capacités de pompage différentes, et que l'étage avec la plus grande capacité de pompage est raccordée à ladite chambre de traitement (2).

4. Installation selon la revendication 3, **caractérisée en ce qu'**une pompe à vide élevé (26), de préférence une pompe à vide turbo-moléculaire, est située dans la ligne de connexion entre ladite chambre de traitement (2) et ladite entrée (14) de l'étage de pompage (11) associé.

5. Procédé d'opération d'une installation multi-chambre (1) dont les chambres (2, 3, 4) servent à traiter des objets sous vide, comprenant un système d'évacuation raccordé auxdites chambres (2, 3, 4), dans lequel
- une pompe à prévide (5) avec plusieurs étages (11, 12, 13) fait partie dudit système d'évacuation,
- les étages de pompage (11, 12, 13) de ladite pompe à prévide (5) sont connectés en parallèle,
- chaque étage est prévu d'une entrée (14, 15, 16),
- chaque entrée est raccordée à une des chambres (2, 3, 4) dudit installation multi-chambre (1),
- chaque étage (11, 12, 13) est prévu d'une sortie (20, 21, 22), et
- les sorties (20, 21, 22) débouchent dans une ligne de sortie commune au sein de ladite pompe à prévide (5),
**caractérisé en ce que** les pressions négatives nécessaires dans les chambres (2, 3, 4,) sont générées à l'aide des étages de pompage (11, 12, 13) de ladite pompe à prévide (5) et que les étages de pompage (11, 12, 13) de la pompe à prévide (5) sont opérées en parallèle.

6. Procédé selon la revendication 5, **caractérisé en ce que** les chambres (2, 3, 4) sont évacuées à l'aide des étages de pompage (11, 12, 13) ayant des capacités de pompage différentes.

7. Procédé selon la revendication 6, **caractérisé en ce qu'**une des chambres (2, 3, 4) est une chambre de traitement (2) et que ladite chambre de traitement (2) est évacuée à l'aide d'un étage de pompage (11) ayant la plus grande capacité de pompage.

8. Procédé selon les revendications 6 ou 7, **caractérisé en ce que** ladite chambre de traitement (2) est évacuée à l'aide d'une pompe à vide élevé (26) et que la pression à prévide nécessaire pour la pompe à vide élevé est produite par un des étages de pompage (2, 3, 4).

9. Système d'évacuation pour une installation multi-chambre (1) dont les chambres (2, 3, 4) servent à traiter des objets sous vide, une pompe à prévide (5) avec plusieurs étages (11, 12, 13) faisant partie dudit système d'évacuation, **caractérisé en ce que** lesdits étages de pompage (11, 12, 13) de ladite pompe à prévide (5) sont arrangés en parallèle, que chaque étage est prévue d'une entrée (14, 15, 16), que chaque entrée sert à établir la connexion avec une des chambres (2, 3, 4), que chaque étage est prévu d'une sortie (20, 21, 22), et que lesdites sorties (20, 21, 22) débouchent dans une ligne de sortie commune au sein de ladite pompe à prévide (5).

10. Système d'évacuation selon la revendication 9, **caractérisé en ce qu'**une pompe à vide élevé (26) fait partie du système et qu'un des étages (11, 12, 13) de ladite pompe à prévide (5) sert à produire le prévide nécessaire pour la pompe à vide élevé (26).

11. Système d'évacuation selon les revendications 9 ou 10, **caractérisé en ce que** les sorties (20, 21, 22) des étages de pompage (11, 12, 13) sont prévues d'un séparateur d'huile (47) commun dans un boîtier externe (28) de ladite pompe à prévide (5).

12. Système d'évacuation selon l'une des revendications 9, 10 ou 11, **caractérisé en ce que** la pompe à prévide (5) est une pompe à vide à palettes rotatives.
